# EUROPEAN PATENT APPLICATION

(11) **EP 4 318 832 A1**
(43) Date of publication of application: **07.02.2024**
(21) Application number: 22774667.4
(22) Date of filing: 31.01.2022
(51) Int. Cl.: H01S 5/16, H01S 5/343

(54) **SEMICONDUCTOR LASER ELEMENT AND METHOD FOR MANUFACTURING SEMICONDUCTOR LASER ELEMENT**

(30) Priority: 26.03.2021 JP 2021052700
(71) Applicant: FURUKAWA ELECTRIC CO., LTD., Chiyoda-ku Tokyo 100-8322 (JP)
(72) Inventor: KAWAKITA, Yasumasa, Tokyo 100-8322 (JP); SAIJO, Yoshito, Tokyo 100-8322 (JP); OHKI, Yutaka, Tokyo 100-8322 (JP)
(74) Representative: SSM Sandmair
(86) International application number: PCT/JP2022/003663
(87) International publication number: WO 2022/201865

(57) **Abstract**

A semiconductor laser device includes, for example: a layered structure in which a first conductivity type cladding layer, an active layer, a second conductivity type cladding layer, and a contact layer are layered in a first direction, the layered structure including a facet in a second direction intersecting the first direction, the facet outputting laser light, a non-window region formed at least in a central portion in the second direction, and a window region formed between the non-window region and the facet, the window region having a bandgap larger than a bandgap of the non-window region; a first electrode electrically connected to the first conductivity type cladding layer; a second electrode that is formed on the contact layer and constitutes a current path through the layered structure with the first electrode; a passivation layer formed on the facet and having a bandgap larger than the bandgap of the window region; and a dielectric reflecting coating that covers an opposite side of the passivation layer from the facet.

## Description

### Field

The present invention relates to a semiconductor laser device and a method for manufacturing a semiconductor laser device.

### Background

In an edge emitting semiconductor laser device, an important issue is to reduce optical damage on an output facet. The optical damage is caused through the following process. That is, when a defect occurs in the output facet, electrons and holes are coupled via the defect, causing the temperature of the facet to increase, and accordingly, reducing the bandgap of the semiconductor material at the facet, and as a result, light absorption increases. The increase in the light absorption causes a cycle in which the temperature of the facet further increases, the bandgap further decreases, and the light absorption further increases, which may finally cause the semiconductor material to melt.

Forming a window region on the facet by impurity diffusion or hole diffusion is known as a technique to reduce such optical damage (for example, Patent Literatures 1 and 2). Since the bandgap near the facet can widen with the window region, light absorption is reduced, and optical damage can be reduced.

### Citation List

### Patent Literature

Patent Literature 1: US 5,703,894
Patent Literature 2: JP 4128898 B2

### Summary

### Technical Problem

In such a semiconductor laser device, occurrence of a disadvantageous event such as a decrease in light output due to the configuration for reducing optical damage is unfavorable.

An object of the present invention is to obtain a semiconductor laser device having a further improved novel configuration capable of, for example, reducing optical damage, and a method for manufacturing the semiconductor laser device.

### Solution to Problem

A semiconductor laser device according to the present invention includes, for example: a layered structure in which a first conductivity type cladding layer, an active layer, a second conductivity type cladding layer, and a contact layer are layered in a first direction, the layered structure including a facet in a second direction intersecting the first direction, the facet outputting laser light, a non-window region formed at least in a central portion in the second direction, and a window region formed between the non-window region and the facet, the window region having a bandgap larger than a bandgap of the non-window region; a first electrode electrically connected to the first conductivity type cladding layer; a second electrode that is formed on the contact layer and constitutes a current path through the layered structure with the first electrode; a passivation layer formed on the facet and having a bandgap larger than the bandgap of the window region; and a dielectric reflecting coating configured to cover an opposite side of the passivation layer from the facet.

In the semiconductor laser device, the passivation layer may be a layer substantially lattice matched with the layered structure.

In the semiconductor laser device, the layered structure may be made of a GaAs-based semiconductor material, and the passivation layer contains GaAs as a layer material.

In the semiconductor laser device, the layered structure may be made of a GaAs-based semiconductor material, and the passivation layer contains a II-IV compound semiconductor material as a layer material.

In the semiconductor laser device, the passivation layer may contain ZnSe as the layer material.

In the semiconductor laser device, the passivation layer may have a thickness of 10 [nm] or more and 150 [nm] or less.

In the semiconductor laser device, the thickness of the passivation layer may be 10 [nm] or more and 50 [nm] or less.

In the semiconductor laser device, impurities may be diffused in the window region.

In the semiconductor laser device, holes may be diffused in the window region.

A method for manufacturing a semiconductor laser device according to the present invention includes, for example: a step of forming a layered structure in which a first conductivity type cladding layer, an active layer, a second conductivity type cladding layer, and a contact layer are layered in a first direction, the layered structure being formed with a non-window region and a window region adjacent to the non-window region in a second direction intersecting the first direction and having a bandgap larger than a bandgap of the non-window region; a step of cleaving the layered structure in the window region in atmosphere to form a facet in the second direction; a step of purifying the facet in ultra-high vacuum; a step of forming a passivation layer having a bandgap larger than the bandgap of the window region on the purified facet in ultra-high vacuum; and a step of forming a dielectric reflecting coating on an opposite side of the passivation layer from the facet.

In the method for manufacturing a semiconductor laser device, in the step of purifying the facet, the facet may be irradiated with plasma to purify the facet.

A method for manufacturing a semiconductor laser device according to the present invention includes, for example: a step of forming a layered structure in which a first conductivity type cladding layer, an active layer, a second conductivity type cladding layer, and a contact layer doped with a second conductivity type impurity are layered on a semiconductor substrate in a first direction, the layered structure being formed with a non-window region and a window region adjacent to the non-window region in a second direction intersecting the first direction and having a bandgap larger than a bandgap of the non-window region; a step of cleaving the layered structure in the window region in ultra-high vacuum to form a facet in the second direction; a step of forming a passivation layer on the facet in ultra-high vacuum; and a step of forming a dielectric reflecting coating on an opposite side of the passivation layer from the facet.

In the method for manufacturing a semiconductor laser device, in the step of forming the passivation layer, the passivation layer may be formed by epitaxial growth.

In the method for manufacturing a semiconductor laser device, the step of forming the passivation layer and the step of forming the dielectric reflecting coating may be performed in chambers connected to each other.

In the method for manufacturing a semiconductor laser device, the step of forming the passivation layer and the step of forming the dielectric reflecting coating may be performed in separate chambers independent from each other.

In the method for manufacturing a semiconductor laser device, in the step of forming the layered structure, the window region may be formed by impurity diffusion or hole diffusion.

### Advantageous Effects of Invention

The present invention makes it possible to obtain a semiconductor laser device having a further improved novel configuration capable of, for example, reducing optical damage, and a method for manufacturing the semiconductor laser device.

### Brief Description of Drawings

FIG. 1 is an exemplary and schematic perspective view of a semiconductor laser device according to an embodiment.
FIG. 2 is a sectional view taken along line II-II in FIG. 1.
FIG. 3 is a sectional view taken along line III-III in FIG. 1.
FIG. 4 is an explanatory diagram illustrating bandgaps of a non-window region, a window region, and a passivation layer according to an embodiment.
FIG. 5 is a flowchart illustrating an example of a procedure for manufacturing a semiconductor laser device according to an embodiment.
FIG. 6 is an exemplary and schematic plan view illustrating a wafer piece in which a plurality of bars including a layered structure of a semiconductor laser device according to an embodiment are arranged in a matrix.
FIG. 7 is an exemplary and schematic perspective view illustrating a step of forming a facet by cleaving in a method for manufacturing a semiconductor laser device according to an embodiment.
FIG. 8 is an exemplary and schematic perspective view illustrating an example of a step of forming a passivation layer using one molecular beam generator in the method for manufacturing a semiconductor laser device according to an embodiment.
FIG. 9 is an exemplary and schematic perspective view illustrating an example of a step of forming a passivation layer using two molecular beam generators in the method for manufacturing a semiconductor laser device according to an embodiment.
FIG. 10 is a flowchart illustrating an example of a procedure of manufacturing a semiconductor laser device according to a modification of the embodiment.
FIG. 11 is an exemplary and schematic configuration diagram illustrating an example of a manufacturing apparatus capable of realizing a manufacturing procedure of a modification of the embodiment.

### Description of Embodiments

Hereinafter, an exemplary embodiment and a modification of the present invention are disclosed. Configurations of the embodiment and the modification described below, and functions and results (effects) provided by the configurations are examples. The present invention can be realized by configurations other than those disclosed in the following embodiment and modification. In addition, the present invention can make it possible to obtain at least one of various effects (including derivative effects) obtained by the configurations.

In the present specification, ordinal numbers are given for convenience to distinguish directions, parts, and the like, and they do not indicate priority or order.

In each drawing, an X direction is represented by an arrow X, a Y direction is represented by an arrow Y, and a Z direction is represented by an arrow Z. The X direction, the Y direction, and the Z direction intersect each other and are orthogonal to each other.

### [Embodiment]

### [Configuration of Semiconductor Laser Device]

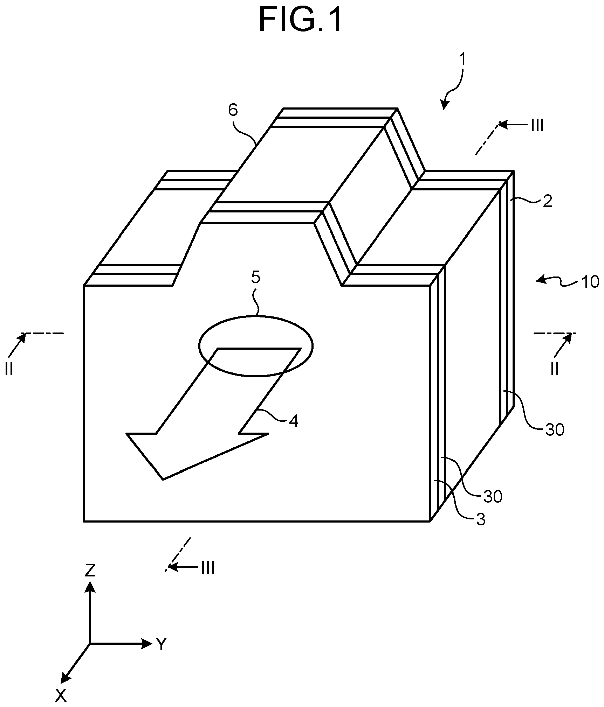

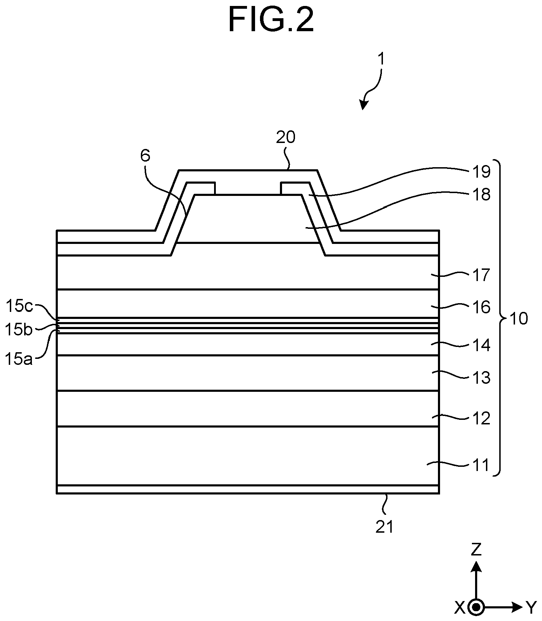

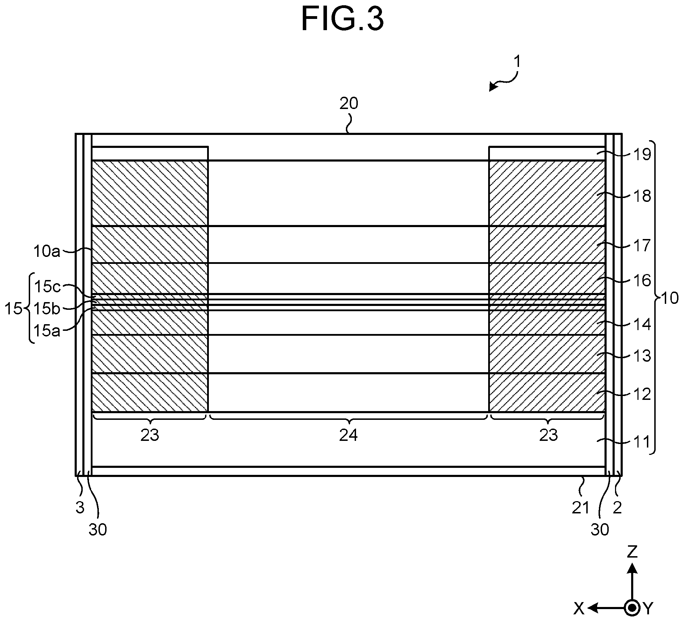

FIG. 1 is a perspective view of a semiconductor laser device 1 according to the present embodiment. FIG. 2 is a sectional view taken along line II-II in FIG. 1, and FIG. 3 is a sectional view taken along line III-III in FIG. 1. The X direction is a radiation direction of laser light from a semiconductor laser device 1. The X direction may also be referred to as a longitudinal direction, and the Y direction may also be referred to as a width direction.

As illustrated in FIG. 1, the semiconductor laser device 1 includes a ridge 6 protruding in the Z direction from a central portion in the Y direction at an end portion in the Z direction. The ridge 6 extends in the X direction having a substantially constant width in the Y direction.

Further, as illustrated in FIG. 1, a low reflecting coating 3 that is spread while crossing the X direction is formed at an end portion of the semiconductor laser device 1 in the X direction, and a high reflecting coating 2 that is spread while crossing the X direction is formed at an end portion of the semiconductor laser device 1 in a direction opposite to the X direction. The low reflecting coating 3 and the high reflecting coating 2 function as reflection mirrors that reflect and resonate generated laser light 4. The laser light 4 is output in the X direction from the facet in the X direction on which the low reflecting coating 3 is formed. The low reflecting coating 3 and the high reflecting coating 2 are examples of dielectric reflecting coatings. The X direction is an example of a second direction.

As illustrated in FIGS. 2 and 3, the semiconductor laser device 1 includes, on a semiconductor substrate 11 that is an n-type GaAs substrate, a layered structure 10 in which an n-buffer layer 12, an n-cladding layer 13, an n-guide layer 14, an active layer 15, a p-guide layer 16, a p-cladding layer 17, a p-contact layer 18, and an insulating layer 19 made of a III-V compound are layered in this order in the Z direction. An upper electrode 20 is formed on an upper portion of the p-contact layer 18, and a lower electrode 21 is formed on a lower portion the semiconductor substrate 11. The p-guide layer 16 formed on the upper side of the active layer 15, the p-cladding layer 17 formed on the side where the p-type cladding is layered with respect to the active layer 15, and the p-contact layer 18 formed for injecting holes into the active layer 15 are doped with Zn as an impurity. In addition, as illustrated in FIGS. 2 and 3, the semiconductor laser device 1 includes the ridge 6 that narrows a current injected into the active layer 15 in a stripe shape and functions as an optical waveguide along the stripe. The semiconductor laser device is processed into a mesa shape in which the width in a direction perpendicular to a laser light radiation direction of a layer region including the upper layer of the p-cladding layer 17 and the p-contact layer 18 is narrowed. The Z direction may also be referred to as a layered direction. The Z direction is an example of a first direction.

As illustrated in FIG. 3, the semiconductor laser device 1 is provided with a non-window region 24 and a window region 23 in which absorption of laser light is smaller than that in the non-window region 24. The non-window region 24 is formed at least at a central portion of the semiconductor laser device 1 in the X direction. The window region 23 is formed between a facet 10a in the X direction and the non-window region 24. The facet 10a is a facet that outputs laser light and may also be referred to as an output facet.

A current path through the layered structure 10 is formed between the lower electrode 21 and the upper electrode 20. The lower electrode 21 is an example of a first electrode, and the upper electrode 20 is an example of a second electrode. The n-cladding layer 13 is an example of a first conductivity type cladding layer, and the p-cladding layer 17 is an example of a second conductivity type cladding layer.

The semiconductor substrate 11 contains n-GaAs as a material. The n-buffer layer 12 is a buffer layer necessary for growing a layered structure of a high-quality epitaxial layer on the semiconductor substrate 11 and contains n-GaAs as a layer material. The refractive index and the thickness of the n-cladding layer 13 and the n-guide layer 14 are set to realize a free-selected optical confinement state with respect to the layered direction. The n-cladding layer 13 and the n-guide layer 14 contain n-AlGaAs as a layer material. The Al composition of the n-guide layer 14 is desirably 15 [%] or more and less than 45 [%]. The Al composition of the n-cladding layer 13 is typically made higher than the Al composition of the n-guide layer 14 to reduce the refractive index. In a high-power edge-emitting multimode semiconductor laser device including the window region 23 of the present embodiment, the coating thickness of the n-guide layer 14 is desirably 200 [nm] or more, for example, about 400 [nm]. The thickness of the n-cladding layer 13 is desirably 1 [µm] or more, for example, about 3 [µm]. As the n-guide layer 14, a layer that is not intentionally doped may be used, but when the thickness of the n-guide layer 14 is set to 100 [nm] or more, the influence of residual impurities is large, and thus doping is preferably performed. The structure and method of the present embodiment may also be applied to an edge-emitting single-mode semiconductor laser device depending on the application.

The active layer 15 includes a lower barrier layer 15a, a quantum well layer 15b, and an upper barrier layer 15c. The lower barrier layer 15a and the upper barrier layer 15c have a function of a barrier that confines carriers in the quantum well layer 15b, and they contain AlGaAs that is not intentionally doped as a material. The quantum well layer 15b contains InGaAs that is not intentionally doped as a material. The emission recombination energy of the confined carriers is determined depending on the structure of the potential well determined by the In composition and coating thickness of the quantum well layer 15b and the composition of the lower barrier layer 15a and the upper barrier layer 15c. The case where the active layer 15 has a configuration of a single quantum well layer (SQW) has been described here. However, the active layer 15 is not limited thereto, and the layer may have a configuration of a multiple quantum well layer (MQW) in which the quantum well layer 15b, the lower barrier layer 15a, and the upper barrier layer 15c are repeatedly layered a predetermined number of times. In addition, here, the configuration with a layer not intentionally doped has been described, but a donor or an acceptor may be intentionally added to the quantum well layer 15b, the lower barrier layer 15a, and the upper barrier layer 15c. Further, since the lower barrier layer 15a and the n-guide layer 14 may have the same composition, and the upper barrier layer 15c and the p-guide layer 16 may have the same composition, the lower barrier layer 15a and the upper barrier layer 15c do not have to be configured.

The p-guide layer 16 and the p-cladding layer 17 are paired with the n-cladding layer 13 and the n-guide layer 14, and their refractive index and the thickness are set to realize a free-selected optical confinement state with respect to the layered direction. The p-guide layer 16 and the p-cladding layer 17 contain p-AlGaAs as a layer material. The Al composition of the p-guide layer 16 is about 20 [%]. The Al composition of the p-cladding layer 17 is typically set higher than the Al composition of the p-guide layer 16. In addition, to reduce the waveguide loss by shifting the optical field in the layer in the direction of the n-cladding layer 13, the Al composition of the p-cladding layer 17 is set slightly higher than that of the n-cladding layer 13. The Al composition of the p-guide layer 16 is set to be lower than the Al composition of the p-cladding layer 17.

In a high-power edge-emitting multimode semiconductor laser device including the window region 23 as in the present embodiment, the coating thickness of the p-guide layer 16 is desirably 200 [nm] or more, and the thickness of the p-cladding layer 17 is desirably about 1 to 2 [µm] . As the p-guide layer 16, a layer that is not intentionally doped may be configured, but when the thickness of the guide layer is set to be thick, the influence of conductivity fluctuation due to residual impurities is large, and thus intentional doping is preferably performed to enhance manufacturing reproducibility. The p-cladding layer 17 is formed of an n-type semiconductor layer. Since the p-contact layer 18 needs to be in contact with an electrode to inject holes into the active layer 15, the p-contact layer is doped with a p-type impurity at a high concentration. A current confinement layer that narrows the injection current and increases the current density in the active layer 15 may be formed in the p-cladding layer 17.

In the semiconductor laser device 1 of the present embodiment, the current injected from the upper electrode 20 and the lower electrode 21 concentrates on a part of the active layer 15 because of the ridge 6 formed by processing a part of the layered structure 10, and the laser light 4 is extracted to the outside of the semiconductor laser device 1. Since the light density of the laser light 4 radiated from a radiation region 5 (see FIG. 1) is high, in the semiconductor laser device 1, the window region 23 in which absorption of laser light is small is provided in a predetermined region including the light output facet, and the other region is set as the non-window region 24 to reduce optical damage.

In the window region 23, at least a part of the semiconductor layer constituting the layered structure 10 of the window region 23 is alloyed. In FIG. 2, the alloyed region is hatched. As a result of the increase in the bandgap of the window region 23 due to alloying, a large difference is generated between the bandgap of the non-window region 24 and the bandgap of the window region 23. This can reduce absorption of laser light in the light output facet region and reduce optical damage in the semiconductor laser device 1.

Impurities or holes are diffused in the window region 23. The impurity is, for example, at least one of Zn, Si, and Mg. The length of the window region 23 in the X direction is typically about several µm in the case of impurity diffusion and about several 10 µm in the case of hole diffusion.

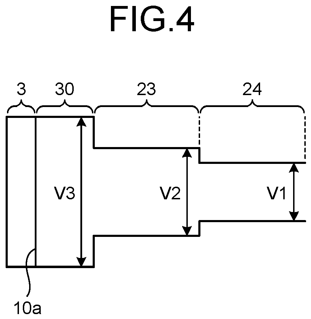

In the present embodiment, a passivation layer 30 is formed by layering a material having a bandgap larger than that of the window region 23 on the facet 10a where the window region 23 is formed through facet growth. The passivation layer 30 is a layer having a bandgap larger than that of the window region 23, which makes it possible to further improve the effect of reducing optical damage. FIG. 4 is an explanatory diagram illustrating bandgaps of the non-window region 24, the window region 23, and the passivation layer 30 according to the present embodiment. Here, the bandgap of the non-window region 24 is a bandgap in the active layer 15, and the bandgap of the window region 23 is a bandgap in a layer corresponding to the active layer 15. As illustrated in FIG. 4, the bandgap V2 of the window region 23 is larger than the bandgap V1 of the non-window region 24, and the bandgap V3 of the passivation layer 30 is larger than the bandgap V2 of the window region 23.

In the present embodiment, the low reflecting coating 3 as a dielectric reflecting coating is provided to cover an opposite side of the passivation layer 30 from the facet 10a.

There is conventionally known a semiconductor laser device in which an alloyed region (window region) is formed by impurity diffusion at an end portion in the X direction of the layered structure 10, and a dielectric reflecting coating is further formed on a facet in the X direction of the alloyed region without forming a passivation layer as in the present embodiment. In this configuration, since an optical loss occurs in the alloyed region, it is difficult to lengthen the alloyed region in the X direction. Accordingly, the length in the X direction of the active layer adjacent to the center side in the X direction with respect to the alloyed region becomes long, and an interval where no current flows is generated in the active layer, the section being adjacent to the alloyed region. In such an interval where no current flows, light is absorbed, which causes a decrease in light output and an increase in energy loss.

In addition, there is conventionally known a semiconductor laser device in which a passivation layer is formed without forming a window region at an end portion of an active layer in an X direction. In this configuration, since a current cannot flow through the interface between the passivation layer and the active layer, it is necessary to provide an interval where no current flows in the active layer, the interval being adjacent to the passivation layer. As described above, in such an interval where no current flows, light is absorbed, which causes a decrease in light output and an increase in energy loss.

In this regard, the present embodiment, in which the non-window region 24, the window region 23, the passivation layer 30, and the low reflecting coating 3 are formed in this order in the X direction as illustrated in FIGS. 3 and 4, can further shorten or eliminate an interval where no current flows in the active layer 15, and thus, can reduce or avoid a decrease in light output and an increase in energy loss. In particular, in the case of the window region 23 in which holes are diffused, the probability of further shortening or eliminating an interval where no current flows in the active layer 15. In addition, from such a viewpoint, it has been found that the thickness of the passivation layer 30 is preferably 10 [nm] or more and 150 [nm] or less, and more preferably 10 [nm] or more and 50 [nm] or less.

### [Manufacturing Method]

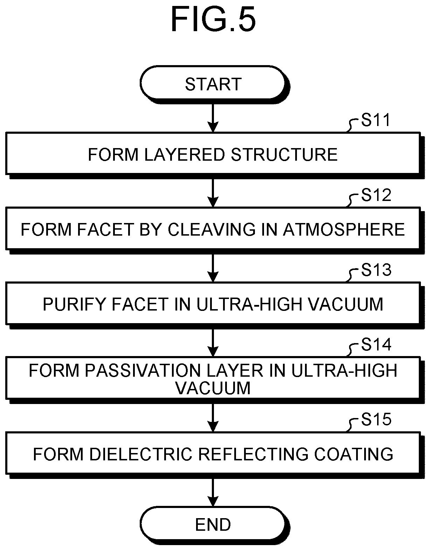

FIG. 5 is a flowchart illustrating an example of a procedure for manufacturing the semiconductor laser device 1 according to the present embodiment. As illustrated in FIG. 5, first, the above-described layered structure 10 is formed (S11).

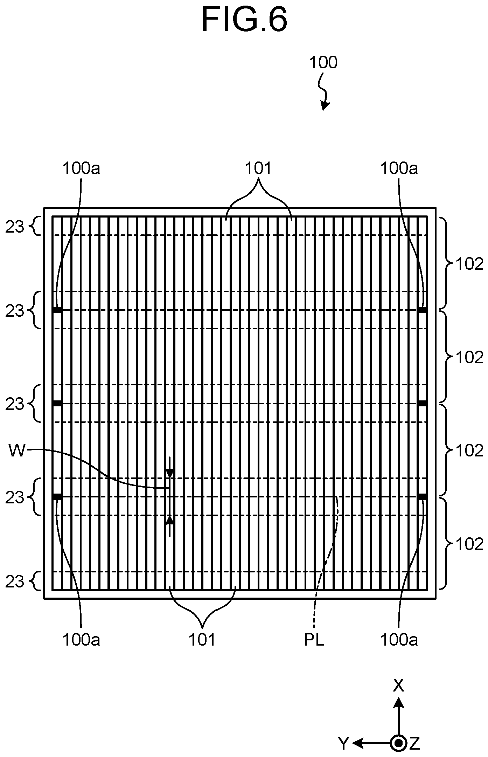

FIG. 6 is a plan view illustrating a wafer piece 100 in which a plurality of bars 101 including the layered structure 10 of the semiconductor laser device 1 are arranged in a matrix in S11. The wafer piece 100 is a part of a wafer (not illustrated) cut out from the wafer.

In S11, the plurality of bars 101 each including the layered structure 10, the window region 23, and the non-window region 24 described above are formed on the wafer (wafer piece 100) by a known semiconductor process. In other words, the layered structure 10, the window region 23, and the non-window region 24 are collectively formed for the plurality of bars 101 by being formed with respect to the wafer (wafer piece 100).

The window region 23 is formed in such a manner to extend in the Y direction having a substantially constant width w in the X direction with respect to the wafer piece 100 about a position (virtual line PL) where a scribe 100a (scratch) is provided. The line PL is a position to be an end portion of each bar 101 in the longitudinal direction in the subsequent step S12.

As illustrated in FIG. 5, after S11, in the present embodiment, the facet 10a in the X direction is formed in each bar 101 included in an array 102 by cleaving the wafer piece 100 in atmosphere (S12).

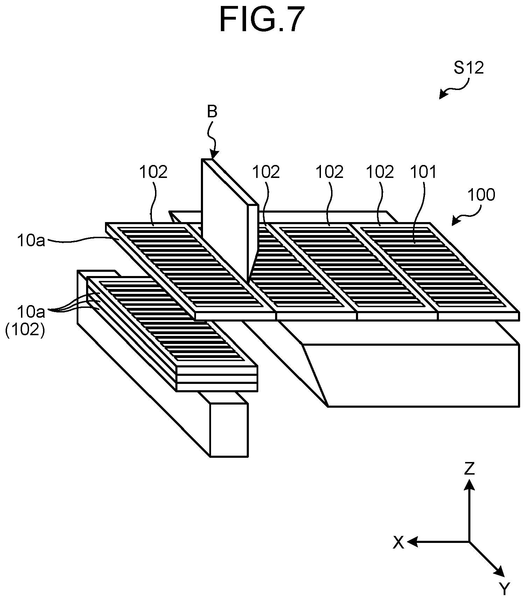

FIG. 7 is a perspective view illustrating a step (S12) of forming the facet 10a by cleaving. As illustrated in FIG. 7, a plurality of arrays 102 are formed by cleaving the wafer piece 100 with a blade B or the like. At this time, the blade B is aligned with the scribe 100a (see FIG. 6) provided in advance. This causes the wafer piece 100 to be cleaved at the position where the scribe 100a is provided, that is, at the line PL, and to be divided into the plurality of arrays 102. Here, since the scribe 100a and the line PL are positioned substantially at the center of the width w of the window region 23, the facet 10a is formed in the window region 23. In addition, as illustrated in FIG. 7, the plurality of divided arrays 102 are stacked in the Z direction.

As illustrated in FIG. 5, after S12, in the present embodiment, the facet 10a is purified in ultra-high vacuum (S13). In S13, the facets 10a of the plurality of stacked arrays 102 are irradiated with plasma such as hydrogen plasma.

As illustrated in FIG. 5, after S13, in the present embodiment, the passivation layer 30 is formed on the facet 10a in ultra-high vacuum (S13).

The passivation layer 30 is a layer substantially lattice matched with the layered structure 10. The passivation layer 30 is formed by epitaxial growth. As described above, the layered structure 10 is made of a GaAs-based semiconductor material. Correspondingly, the passivation layer 30 contains, for example, a III-V compound such as GaAs or a II-IV compound such as ZnSe as a layer material (semiconductor material).

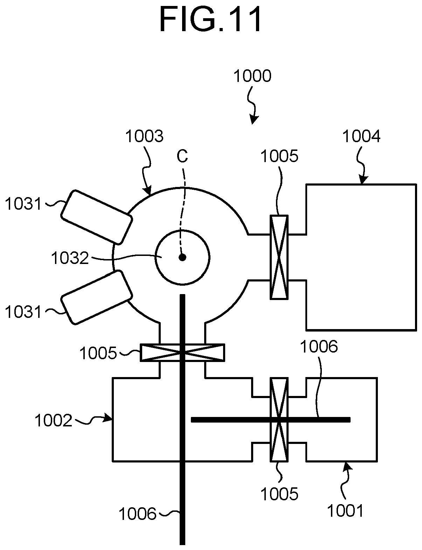

The passivation layer 30 is formed in a facet growth chamber 1003 (see FIG. 11) that is brought into an ultra-high vacuum state. The plurality of arrays 102 is heated to a processing temperature of, for example, about 300 [°C] by a heater or the like provided in the facet growth chamber 1003.

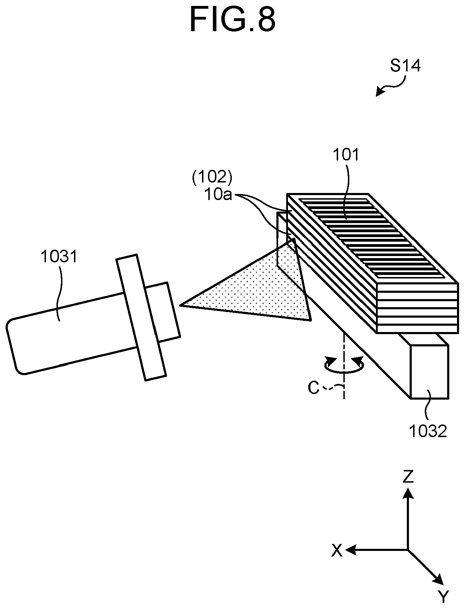

FIG. 8 is a perspective view illustrating an example of a step (S13) of forming the passivation layer 30. As illustrated in FIG. 8, the passivation layer 30 is formed collectively for the plurality of arrays 102 layered in a state where the facets 10a are arranged substantially flush with each other in the Z direction.

In the example of FIG. 8, the passivation layer 30 is formed by irradiating the facets 10a of the arrays 102 with a molecular beam generated by one molecular beam generator 1031.

When the passivation layer 30 containing a ZnSe compound as a II-IV compound is formed, the molecular beam generator 1031 may be realized by using, for example, a Knudsen cell. In this case, the molecular beam generator 1031 generates a molecular beam of Zn and low molecular weight Se from a ZnSe compound raw material held therein and irradiates the facets 10a of the plurality of arrays 102 with the molecular beam. This causes a ZnSe coating to form on the facets 10a through epitaxial growth. Since the rate of epitaxial growth is determined by the element with a lower molecular beam intensity among the constituent elements of the molecular beam, a high-quality ZnSe coating can be obtained even in epitaxial growth using one molecular beam generator 1031.

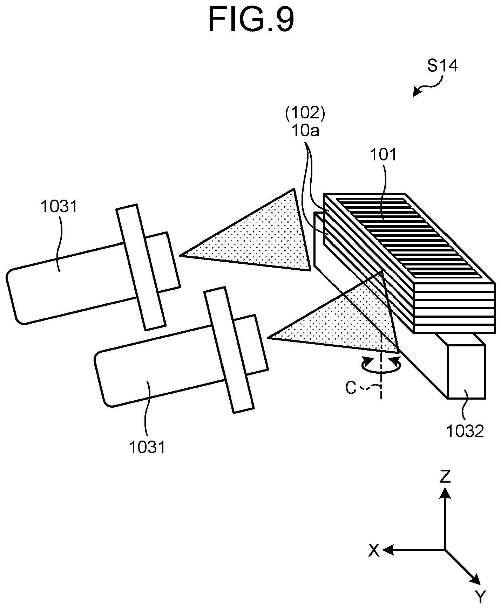

FIG. 9 is a perspective view illustrating another example of the step (S13) of forming the passivation layer 30. As illustrated in FIG. 9, in this case as well, the passivation layer 30 is formed collectively for the plurality of arrays 102 layered in a state where the facets 10a are arranged substantially flush with each other in the Z direction.

In the example of FIG. 9, the passivation layer 30 is formed by irradiating the facets 10a of the arrays 102 with molecular beams generated by two molecular beam generators 1031.

When the passivation layer 30 containing a ZnSe compound as a II-IV compound is formed, the two molecular beam generators 1031 may be realized using a Knudseng cell or a valved cell. As an example, one molecular beam generator 1031 generates and emits a molecular beam of Zn, and the other molecular beam generator 1031 generates and emits a molecular beam of Se. This causes a ZnSe coating to form on the facets 10a through epitaxial growth. The molecular beam generator 1031 that emits a molecular beam of Sn is preferably realized using a valved cracking cell to reduce the molecular weight of Se.

The combination of the two molecular beam generators 1031 in the case of forming the passivation layer 30 containing a ZnSe compound is not limited to the above-described combination, and various settings may be taken. For example, one molecular beam generator 1031 may emit a molecular beam of ZnSe, and the other molecular beam generator 1031 may emit a molecular beam of either Zn or Se. The two molecular beam generators may each emit a molecular beam of ZnSe.

When the passivation layer 30 containing a ZnSe compound is formed, the facet 10a may be first irradiated with only a molecular beam of Zn from the molecular beam generator 1031. This configuration can reduce the occurrence of through transition at the interface between the layered structure 10 made of a GaAs-based semiconductor material and the passivation layer 30 containing a ZnSe compound and can further improve the reliability of the semiconductor laser device 1.

When the passivation layer 30 containing a GaAs compound as a III-V compound is formed using two molecular beam generators 1031, one molecular beam generator 1031 emits a molecular beam of Ga, and the other molecular beam generator 1031 emits a molecular beam of As. In this case, as an example, the molecular beam generator 1031 that emits a molecular beam of Ga may be realized by using a Knudsen cell, and the molecular beam generator 1031 that emits a molecular beam of As may be realized by using a valved cracking cell. The irradiation of a molecular beam from the molecular beam generator 1031 forms a GaAs coating on the facet 10a through epitaxial growth.

Using a plurality of molecular beam generators 1031 can reduce variations in the components and the thickness of the passivation layer 30 depending on the position of the facet 10a as compared with the case where the molecular beam generator 1031 is used. The number of molecular beam generators 1031 is not limited to two, and the number may be three or more.

The passivation layer 30 is formed on the facets 10a in the X direction of the arrays 102 and is also formed on the facets 10a in the direction opposite to the X direction of the arrays 102. To form the passivation layer 30 on both facets 10a, a support device 1032 is equipped with, for example, a turntable that can rotate at least 180° around a central axis C extending in the Z direction.

As illustrated in FIG. 5, after S14, in the present embodiment, the low reflecting coating 3 is formed on the passivation layer 30 formed on the facet 10a in the X direction, and the high reflecting coating 2 is formed on the passivation layer 30 formed on the facet 10a in the direction opposite to the X direction (S15). The low reflecting coating 3 and the high reflecting coating 2 may be formed with a sputtering device, a plasma CVD device, or the like provided separately from the facet growth chamber 1003 in which epitaxial growth has been performed. Since the facet 10a is protected by the passivation layer 30 formed in S14, the facet 10a hardly deteriorates even with exposure of the array 102 to atmosphere at the time of transition from S14 to S15.

In this manner, in the present embodiment, the passivation layer 30 having a larger bandgap than that of the window region 23 is formed on the facet 10a provided in the window region 23, and the low reflecting coating 3 (dielectric reflecting coating) is formed on an opposite side of the passivation layer 30 from the facet 10a.

According to such a configuration and method, an interval where no current flows in the active layer 15 can be shortened or eliminated, for example, and thus it is possible to reduce or avoid occurrence of a disadvantageous event such as a decrease in light output or an increase in energy loss due to a presence of an interval where no current flows in the active layer 15 in the conventional structure. That is, the present embodiment can make it possible to obtain the semiconductor laser device 1 having further improved novel configuration capable of reducing optical damage, and a method for manufacturing the semiconductor laser device 1.

### [Modification]

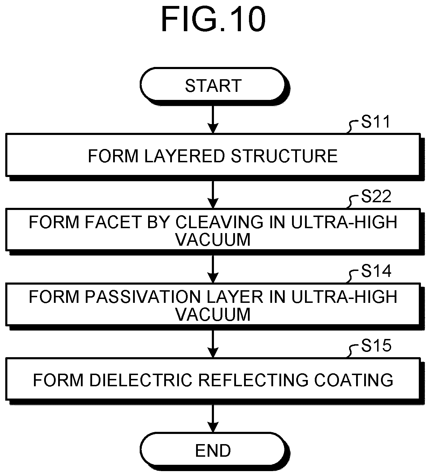

FIG. 10 is a flowchart illustrating an example of a procedure of manufacturing the semiconductor laser device 1 according to a modification of the present embodiment. As is clear from comparison between FIG. 10 and FIG. 5, in the present modification, instead of S11 and S12 of the embodiment, the facet 10a is formed by cleaving the wafer piece 100 in the window region 23 in ultra-high vacuum (S22). Such a procedure makes it possible to reduce formation of a natural oxide coating on the facet 10a, adhesion of particles to the facet 10a, and the like without performing a process of purifying the facet 10a in ultra-high vacuum and further improve reliability.

FIG. 11 is a configuration diagram illustrating an example of a manufacturing apparatus 1000 capable of realizing the manufacturing procedure of the modification. The manufacturing apparatus 1000 includes a load lock chamber 1001, a cleaving chamber 1002, a facet growth chamber 1003, and a coating chamber 1004.

In addition, a gate valve 1005 that opens and closes between the chambers and hermetically seals the chambers in a closed state is provided between the chambers. The manufacturing apparatus 1000 is provided with a conveyance mechanism 1006 that conveys the wafer piece 100 and the arrays 102 between the chambers. The conveyance mechanism 1006 may be configured as, for example, a conveyance trolley, a conveyance arm, or the like.

The load lock chamber 1001 includes an opening/closing door (not illustrated). In the load lock chamber 1001, loading of the wafer piece 100 and unloading of the arrays 102 are performed.

In the cleaving chamber 1002, cleaving (S12) as illustrated in FIG. 7 is performed in an ultra-high vacuum state.

The facet growth chamber 1003 is an epitaxial growth device. In the facet growth chamber 1003, the passivation layer 30 as illustrated in FIGS. 8 and 9 is formed, that is, facet growth (S22) is performed. The facet growth chamber 1003 is provided with the molecular beam generator 1031 and the support device 1032 having a heater and a turntable.

In the coating chamber 1004, the low reflecting coating 3 and the high reflecting coating 2 are formed (S15). In the present modification, the facet growth chamber 1003 and the coating chamber 1004 are connected to each other, but the present invention is not limited thereto, and the facet growth chamber 1003 and the coating chamber 1004 may be independent from each other. In this case, between the facet growth chamber 1003 and the coating chamber 1004, the arrays 102 may be exposed to atmosphere.

Although the embodiment and the modification of the present invention have been exemplified above, the embodiment and the modification are merely examples, and are not intended to limit the scope of the invention. The above-described embodiment and modification can be implemented in various other forms, and various omissions, substitutions, combinations, and changes can be made without departing from the gist of the invention. In addition, specifications (structure, type, direction, model, size, length, width, thickness, height, number, arrangement, position, material, and the like) of each configuration, shape, and the like can be appropriately changed and implemented.

For example, the semiconductor laser device does not have to include a ridge.

### Industrial Applicability

The present invention can be used for a semiconductor laser device and a method for manufacturing a semiconductor laser device.

### Reference Signs List

1 SEMICONDUCTOR LASER DEVICE
2 HIGH REFLECTING COATING (DIELECTRIC REFLECTING COATING)
3 LOW REFLECTING COATING (DIELECTRIC REFLECTING COATING)
4 LASER LIGHT
5 RADIATION REGION
6 RIDGE
10 LAYERED STRUCTURE
10a FACET
11 SEMICONDUCTOR SUBSTRATE
12 n-BUFFER LAYER
13 n-CLADDING LAYER (FIRST CONDUCTIVITY TYPE CLADDING LAYER)
14 n-GUIDE LAYER
15 ACTIVE LAYER
15a LOWER BARRIER LAYER
15b QUANTUM WELL LAYER
15c UPPER BARRIER LAYER
16 p-GUIDE LAYER
17 p-CLADDING LAYER (SECOND CONDUCTION TYPE CLADDING LAYER)
18 p-CONTACT LAYER
19 INSULATING LAYER
20 UPPER ELECTRODE (SECOND ELECTRODE)
21 LOWER ELECTRODE (FIRST ELECTRODE)
23 WINDOW REGION
24 NON-WINDOW REGION
30 PASSIVATION LAYER
100 WAFER PIECE
100a SCRIBE
101 BAR
102 ARRAY
1000 MANUFACTURING APPARATUS
1001 LOAD LOCK CHAMBER
1002 CLEAVING CHAMBER
1003 FACET GROWTH CHAMBER
1004 COATING CHAMBER
1005 GATE VALVE
1006 CONVEYANCE MECHANISM
1031 MOLECULAR BEAM GENERATOR
1032 SUPPORT DEVICE
B BLADE
C CENTRAL AXIS
V1, V2, V3 BANDGAP
w WIDTH
X DIRECTION (SECOND DIRECTION)
Y DIRECTION
Z DIRECTION (FIRST DIRECTION)

## Claims

1. A semiconductor laser device comprising:
a layered structure in which a first conductivity type cladding layer, an active layer, a second conductivity type cladding layer, and a contact layer are layered in a first direction, the layered structure including
a facet in a second direction intersecting the first direction, the facet outputting laser light,
a non-window region formed at least in a central portion in the second direction, and
a window region formed between the non-window region and the facet, the window region having a bandgap larger than a bandgap of the non-window region;
a first electrode electrically connected to the first conductivity type cladding layer;
a second electrode that is formed on the contact layer and constitutes a current path through the layered structure with the first electrode;
a passivation layer formed on the facet and having a bandgap larger than the bandgap of the window region; and
a dielectric reflecting coating configured to cover an opposite side of the passivation layer from the facet.

2. The semiconductor laser device according to claim 1, wherein the passivation layer is a layer substantially lattice matched with the layered structure.

3. The semiconductor laser device according to claim 2, wherein the layered structure is made of a GaAs-based semiconductor material, and the passivation layer contains GaAs as a layer material.

4. The semiconductor laser device according to claim 2, wherein the layered structure is made of a GaAs-based semiconductor material, and the passivation layer contains a II-IV compound semiconductor material as a layer material.

5. The semiconductor laser device according to claim 4, wherein the passivation layer contains ZnSe as the layer material.

6. The semiconductor laser device according to any one of claims 1 to 5, wherein the passivation layer has a thickness of 10 [nm] or more and 150 [nm] or less.

7. The semiconductor laser device according to claim 6, wherein the thickness of the passivation layer is 10 [nm] or more and 50 [nm] or less.

8. The semiconductor laser device according to any one of claims 1 to 7, wherein impurities are diffused in the window region.

9. The semiconductor laser device according to any one of claims 1 to 8, wherein holes are diffused in the window region.

10. A method for manufacturing a semiconductor laser device, the method comprising:
a step of forming a layered structure in which a first conductivity type cladding layer, an active layer, a second conductivity type cladding layer, and a contact layer are layered in a first direction, the layered structure being formed with a non-window region and a window region adjacent to the non-window region in a second direction intersecting the first direction and having a bandgap larger than a bandgap of the non-window region;
a step of cleaving the layered structure in the window region in atmosphere to form a facet in the second direction;
a step of purifying the facet in ultra-high vacuum;
a step of forming a passivation layer having a bandgap larger than the bandgap of the window region on the purified facet in ultra-high vacuum; and
a step of forming a dielectric reflecting coating on an opposite side of the passivation layer from the facet.

11. The method for manufacturing a semiconductor laser device according to claim 10, wherein in the step of purifying the facet, the facet is irradiated with plasma to purify the facet.

12. A method for manufacturing a semiconductor laser device, the method comprising:
a step of forming a layered structure in which a first conductivity type cladding layer, an active layer, a second conductivity type cladding layer, and a contact layer doped with a second conductivity type impurity are layered on a semiconductor substrate in a first direction, the layered structure being formed with a non-window region and a window region adjacent to the non-window region in a second direction intersecting the first direction and having a bandgap larger than a bandgap of the non-window region;
a step of cleaving the layered structure in the window region in ultra-high vacuum to form a facet in the second direction;
a step of forming a passivation layer on the facet in ultra-high vacuum; and
a step of forming a dielectric reflecting coating on an opposite side of the passivation layer from the facet.

13. The method for manufacturing a semiconductor laser device according to any one of claims 10 to 12, wherein in the step of forming the passivation layer, the passivation layer is formed by epitaxial growth.

14. The method for manufacturing a semiconductor laser device according to any one of claims 10 to 13, wherein the step of forming the passivation layer and the step of forming the dielectric reflecting coating are performed in chambers connected to each other.

15. The method for manufacturing a semiconductor laser device according to any one of claims 10 to 14, wherein the step of forming the passivation layer and the step of forming the dielectric reflecting coating are performed in separate chambers independent from each other.

16. The method for manufacturing a semiconductor laser device according to any one of claims 10 to 15, wherein in the step of forming the layered structure, the window region is formed by impurity diffusion or hole diffusion.
